# EUROPEAN PATENT APPLICATION

(11) **EP 2 031 663 A2**
(43) Date of publication of application: **04.03.2009**
(21) Application number: 08252822.5
(22) Date of filing: 26.08.2008
(51) Int. Cl.: H01L 31/048, H01L 31/05, H01L 31/18

(54) **Solar cell module, method for manufacturing the same, solar cell, and method for manufacturing the same**

(30) Priority: 27.08.2007 JP 2007219294
(71) Applicant: Sanyo Electric Co., Ltd., Osaka 570-8677 (JP)
(72) Inventor: Nakai, Takuo, Moriguchi-shi, Osaka 570-8677 (JP); Shima, Masaki, Moriguchi-shi, Osaka 570-8677 (JP)
(74) Representative: Calderbank, Thomas Roger

(57) **Abstract**

A method for manufacturing a solar cell module according to the present invention includes a step of forming a protective layer formed of a transparent material on one main surface of one solar cell, and a region in which the one main surface is exposed remains on an outside of the circumference of the protective layer formed on the one main surface.

## Description

This application is based upon and claims the benefit of priority from the prior Japanese Patent Application No. P 2007-219294, filed on August 27, 2007; the entire contents of which are incorporated herein by reference.

The present invention relates to a solar cell module including a plurality of solar cells arranged in an arrangement direction and a wiring member configured to connect the plurality of solar cells to each other, a method for manufacturing the solar cell module, a solar cell having a protective layer formed of a resin material on one main surface thereof, and a method for manufacturing the solar cell.

Solar cells have been expected to be a new energy source, since the solar cells can directly convert clean and inexhaustibly supplied sunlight into electricity.

Generally, a single solar cell has an energy output of only approximately several W. Accordingly, when using the solar cell as a power source for a house, a building, etc., used is a solar cell module in which a plurality of solar cells are electrically connected to each other to enhance energy output. The solar cell module includes a group of solar cells formed by connecting a plurality of solar cells arranged in an arrangement direction to each other using a wiring member.

Specifically, in the group of solar cells, a light receiving surface of one solar cell and a back surface of a different solar cell adjacent to one side of the one solar cell are electrically connected by the wiring member. Additionally, a back surface of the one solar cell and a light receiving surface of a still different solar cell adjacent to the other side of the one solar cell are electrically connected to each other by the wiring member.

Here, formation of a protective layer on the light receiving surface of each solar cell that forms a group of solar cells has been known (for example, see Japanese Patent Application Publication No. 2007-141967). In the process of forming the protective layer, a resin material having translucency is applied to the light receiving surface of the solar cell mounted on a mounting base.

The protective layer is formed for the purpose of protecting the light receiving surface of the solar cell against cracks or moisture in the atmosphere. Therefore, the resin material is preferably applied thoroughly to the light receiving surface including the circumference thereof.

However, adhesion of the resin material to a wiring member connection region to which the wiring member is connected reduces adhesiveness of the wiring member to the light receiving surface, and causes faulty connection between the light receiving surface and the wiring member. For this reason, on the light receiving surface of the solar cell mounted on the mounting base, the resin material is not applied to an inner side and the circumference of the wiring member connection region.

The resin material has high fluidity immediately after being applied on the light receiving surface of the solar cell. Accordingly, when the resin material is applied to the circumference of the light receiving surface, the applied resin material may overflow onto the mounting base from the circumference of the solar cell.

In recent years, the solar cells are reduced in thickness, as well as in weight to a great extent. For this reason, the resin material that overflows onto the mounting base may intrude into a space between the solar cell and the mounting base, and may adhere to a wiring member connection region on the back surface of the solar cell. Accordingly, a problem is caused that the faulty connection between the back surface and a wiring member to be connected thereto occurs.

Moreover, the resin material also has high adhesiveness immediately after being applied to the light receiving surface of the solar cell. Therefore, the resin material that overflows onto the mounting base may fix the solar cell and the mounting base. As a result, a problem arises that the solar cell is damaged when being detached from the mounting base, and thereby the production efficiency of the solar cell is reduced.

The present invention has been devised in view of the above-mentioned problems. Preferably, an object of the present invention is to provide: a method for manufacturing a solar cell module that can avoid reduction in production efficiency of a solar cell while suppressing occurrence of faulty connection between a back surface of the solar cell and a wiring member; the solar cell module; a solar cell that forms the solar cell module; and a method for manufacturing the solar cell.

A method for manufacturing a solar cell module according to an aspect of the present invention is a method for manufacturing a solar cell module one solar cell and other solar cell which are arranged in an arrangement direction, and a wiring member configured to electrically connect the one solar cell with the other solar cell, the method comprising the steps of forming a protective layer formed of a resin material on one main surface of the one solar cell; and arranging the wiring member on the one main surface. In the method in the forming step, a region in which the one main surface is exposed is provided so as to surround the protective layer.

According to the method for manufacturing the solar cell module according to the aspect of the present invention, the region in which the one main surface is exposed remains on an outside of an circumference of the protective layer formed on the one main surface of the one solar cell. Therefore, even when a transparent member that forms the protective layer has high fluidity, the transparent member does not overflow to the outside of the one main surface. Thus, faulty connection between a wiring member and the other main surface provided on a side opposite to the one main surface can be prevented from occurring, and simultaneously, reduction in the production efficiency of the one solar cell can be avoided.

In the method for manufacturing the solar cell module according to the aspect of the present invention, in the forming step, the region in which the one main surface is exposed may be provided as a region in which the wiring member is arranged.

A solar cell module according to an aspect of the present invention is a solar cell module including one solar cell and other solar cell which are arranged in an arrangement direction, and a wiring member configured to electrically connect the one solar cell with the other solar cell. In the solar cell module, the one solar cell includes one main surface; and a protective layer formed of a transparent member on the one main surface, the wiring member is arranged on the one main surface, and a region in which the one main surface is exposed is formed in the one solar cell so as to surround the protective layer.

A method for manufacturing a solar cell according to an aspect of the present invention is a method for manufacturing a solar cell having a protective layer formed of a resin material on one main surface. The method includes a step of: forming the protective layer on the one main surface. In the method in the forming step, a region in which the one main surface is exposed is provided so as to surround the protective layer.

A solar cell according to an aspect of the present invention includes a solar cell including one main surface; and a protective layer formed of a transparent member on the one main surface, In the solar cell, a region in which the one main surface is exposed is formed so as to surround the protective layer.

IN THE DRAWINGS :
Fig. 1 is a side view of a solar cell module 100 according to a first embodiment of the present invention;
Fig. 2 is a plan view of a light receiving surface side of a solar cell 10 according to the first embodiment of the present invention (1);
Fig. 3 is a sectional view of the solar cell 10 according to the first embodiment of the present invention (sectional view taken along the line A-A of Fig. 2);
Fig. 4 is a sectional view of the solar cell 10 according to the first embodiment of the present invention (sectional view taken along the line B-B of Fig. 2);
Fig. 5 is a plan view of the light receiving surface side of the solar cell 10 according to the first embodiment of the present invention (2);
Fig. 6 is a schematic diagram showing a method for forming a protective layer according to the first embodiment of the present invention;
Fig. 7 is a plan view of a light receiving surface side of a solar cell according to Example; and
Fig. 8 is a diagram showing an energy output value of a solar cell after humidity resistance test.

Next, preferred embodiments of the present invention will be described using the drawings. In the description of the drawings below, identical or similar numerals are given to identical or similar portions. However, it should be noted that the drawings are schematic and a dimensional ratio and the like is different from actual ones. Accordingly, specific sizes or the like should be determined in consideration of the description below. Moreover, needless to say, there are some differences in dimensional relationships and ratios between the mutual drawings.

### [First embodiment]

### (Schematic configuration of Solar Cell Module)

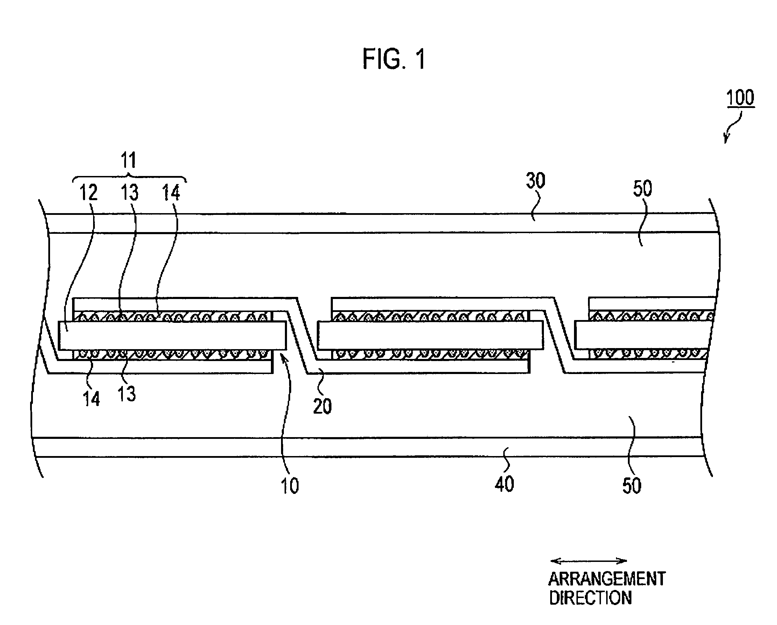

Hereinafter, a schematic configuration of a solar cell module according to a first embodiment of the present invention will be described with reference to Fig. 1. Fig. 1 is a side view of the solar cell module 100 according to the first embodiment of the present invention.

As shown in Fig. 1, the solar cell module 100 includes a plurality of solar cells 10, a wiring member 20, a light-receiving-surface-side protective member 30, a back-surface-side protective member 40, and a sealing member 50.

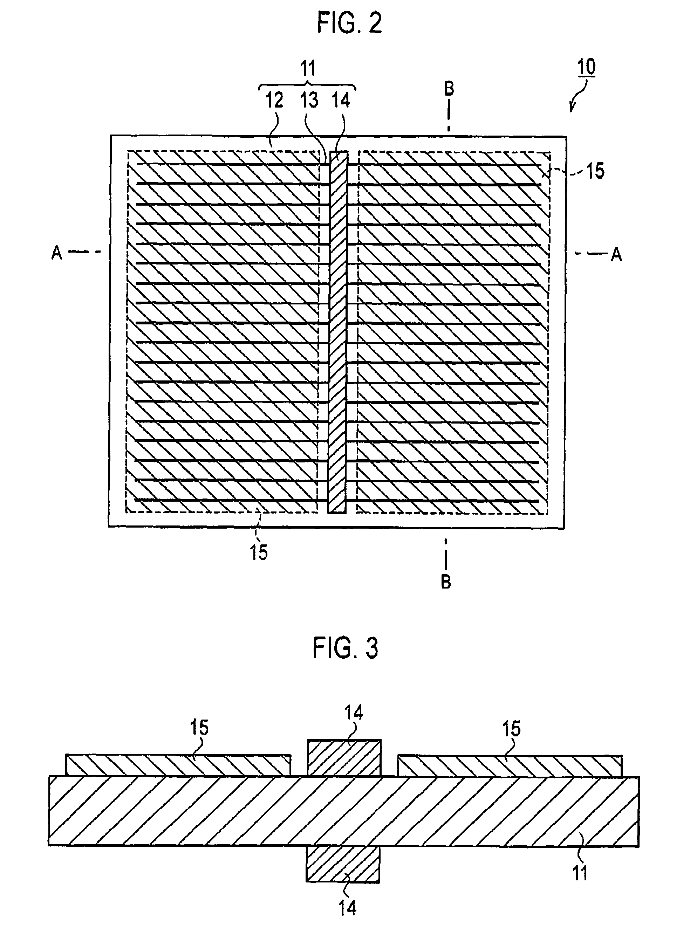

The solar cell 10 includes a solar cell substrate 11 and a protective layer 15 (not shown in Fig. 1; see Fig. 2). The solar cell substrate 11 includes a photoelectric conversion part 12, a thin wire electrode 13, and a connecting electrode 14. The solar cell 10 also has a light receiving surface (upper surface in the drawing) through which sunlight enters, and a back surface (bottom surface in the drawing) provided on the rear side of the light receiving surface. The light receiving surface and the back surface constitute main surfaces of the solar cell 10. The thin wire electrode 13 and the connecting electrode 14 are respectively formed on the light receiving surface of the solar cell 10 and on the back surface of the solar cell 10. A configuration of the solar cell 10 will be described later.

The wiring member 20 electrically connects a plurality of solar cells 10 arranged in an arrangement direction.

Specifically, the wiring member 20 is connected to a connecting electrode 14 formed in the arrangement direction on the light receiving surface of one solar cell 10, and also connected to a connecting electrode 14 formed in the arrangement direction on the back surface of a different solar cell 10 adjacent to one side of the one solar cell 10. In addition, the wiring member 20 is connected to a connecting electrode 14 formed in the arrangement direction on the back surface of the one solar cell 10, and also connected to a connecting electrode 14 formed in the arrangement direction on the light receiving surface of still different solar cell 10 adjacent to the other side of the one solar cell 10. Thereby, the one solar cell 10, the different solar cell 10 adjacent to the one side of the one solar cell 10, and the still different solar cell 10 adjacent to the other side of the one solar cell 10 are electrically connected.

A conductive material, such as copper molded into a thin plate shape or twisted line shape, can be used for the wiring member 20. It should be noted that soft conductive materials, such as eutectic solder, may be plated on a surface of the thin plate shape copper and the like used for the wiring member 20.

The light-receiving-surface-side protective member 30 is disposed on the light receiving surface side of the sealing member 50 to protect the surface of the solar cell module 100. For the light-receiving-surface-side protective member 30, material having translucency and waterproofness such as glass, or translucent plastics, can be used.

The back-surface-side protective member 40 is disposed on the back surface side of the sealing member 50 to protect the back surface of the solar cell module 100. For the back-surface-side protective member 40, a resin film such as polyethylene terephthalate (PET), a stacked film having a structure in which an Al foil is sandwiched between resin films and the like can be used.

The sealing member 50 seals a plurality of solar cells 10 between the light-receiving-surface-side protective member 30 and the back-surface-side protective member 40, the plurality of solar cells 10 being electrically connected by the wiring member 20. For the sealing member 50, resins having translucency, such as EVA, EEA, PVB, silicone resins, urethane resins, acrylic resins, epoxy resins, can be used.

An Al frame (not shown) can be attached to the circumference of the solar cell module 100 having the above-mentioned configuration.

### (Configuration of solar cell)

Hereinafter, a configuration of a solar cell according to the first embodiment of the present invention will be described with reference to Fig. 2. Fig. 2 is a plan view of the light receiving surface side of the solar cell 10 according to the first embodiment of the present invention.

As shown in Fig. 2, the solar cell 10 includes the solar cell substrate 11 and the protective layer 15. The solar cell substrate 11 includes the photoelectric conversion part 12, the thin wire electrode 13, and the connecting electrode 14.

The photoelectric conversion part 12 generates a photocarrier by receiving the sunlight on the light receiving surface. The photocarrier refers to an electron hole and an electron which are generated from the sunlight being absorbed by the photoelectric conversion part 12. The photoelectric conversion part 12 has an n type region and a p type region therein. A semiconductor junction is formed at an interface portion of the n type region and the p type region in the photoelectric conversion part 12. The photoelectric conversion part 12 can be formed using a semiconductor substrate formed of semiconductor materials including crystalline semiconductor materials such as monocrystalline Si and polycrystalline Si, compound semiconductor materials such as GaAs, InP, etc. The photoelectric conversion part 12 may have the so-called HIT structure, i.e., a structure in which a substantially intrinsic amorphous silicon layer is sandwiched between a monocrystalline silicon substrate and an amorphous silicon layer, thereby reducing defects in the interface, and improving properties of a hetero junction interface.

The thin wire electrode 13 is an electrode that collects the photogenerated carriers from the photoelectric conversion part 12. As shown in Fig. 2, the thin wire electrode 13 is formed in a line form in a direction approximately perpendicular to the arrangement direction. A plurality of thin wire electrodes 13 are formed, for example, over the approximately whole region of the light receiving surface of the photoelectric conversion part 12. The thin wire electrode 13 can be formed using a resin-type conductive paste including a resin material as a binder and conductive particles such as silver particles as a filler, but the thin wire electrode 13 is not limited to be formed in this way. As shown in Fig. 1, the thin wire electrode 13 is also formed on the back surface of the photoelectric conversion part 12.

The connecting electrode 14 is an electrode that collects the photogenerated carriers from several thin wire electrodes 13. As shown in Fig. 2, the connecting electrode 14 is formed in the arrangement direction in such a way to intersect with the thin wire electrode 13. The connecting electrode 14 can be formed using, for example, a resin-type conductive paste including a resin material as a binder and conductive particles such as silver particles as a filler, but the connecting electrode is not limited to be formed in this way. As shown in Fig. 1, the connecting electrode 14 is also formed on the back surface of the photoelectric conversion part 12.

The number of the connecting electrodes 14 can be set to a suitable number in consideration of size of the photoelectric conversion part 12 and the like. The solar cell 10 according to the first embodiment of the present invention includes a single connecting electrode 14.

The protective layer 15 is a thin film that protects the light receiving surface of the solar cell substrate 11. Specifically, the protective layer 15 suppresses damages to a region on the light receiving surface of the solar cell substrate 11 where the photoelectric conversion part 12 is exposed, and damages to the thin wire electrode 13 formed on the light receiving surface of the photoelectric conversion part 12. In addition, the protective layer 15 blocks out, from the atmosphere, the region in which the light receiving surface of the photoelectric conversion part 12 is exposed. This prevents the components of the photoelectric conversion part 12 from being ionized due to moisture in the atmosphere, and the pn semiconductor junction of the photoelectric conversion part 12 from being deteriorated. Thus, the protective layer 15 protects the light receiving surface of the solar cell substrate 11 against damages and moisture, thereby, preventing reduction in photoelectric conversion efficiency of the solar cell substrate 11.

For the protective layer 15, translucent resins, such as EVA, PVA, PVB, silicone resins, acrylic resins, epoxy resins, and polysilazane, can be used. In addition, additives, such as silicon oxide, aluminum oxide, magnesium oxide, titanium oxide, and zinc oxide, may be added to these resins.

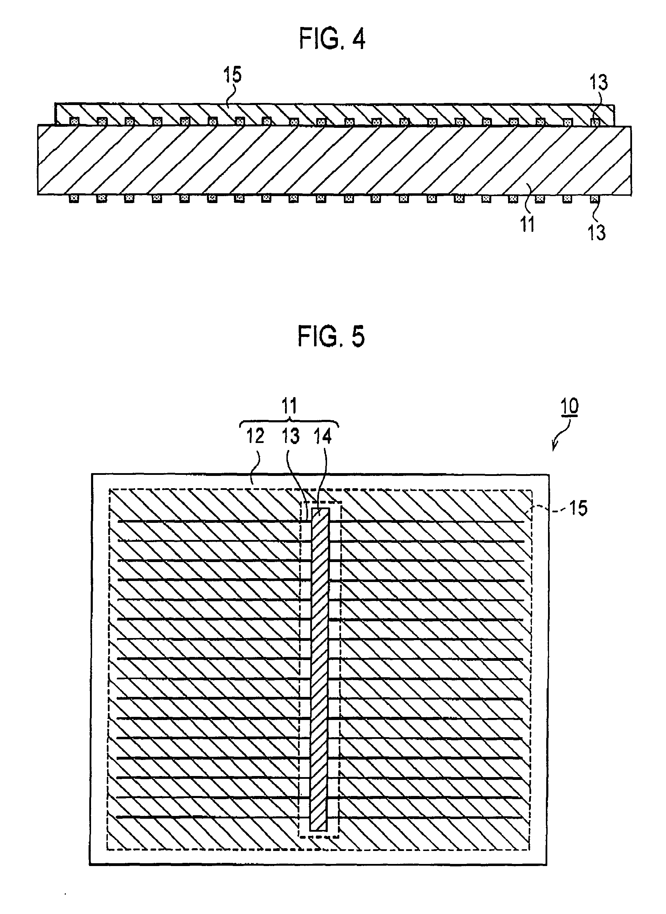

Here, a region in which the protective layer 15 is formed will be described with reference to Figs. 2, 3, and 4. Fig. 3 is a sectional view taken along the line A-A of Fig. 2. Fig. 4 is s sectional view taken along the line B-B of Fig. 2.

As shown in Figs. 2, 3, and 4, on the light receiving surface of the solar cell substrate 11, a region in which the light receiving surface of the solar cell substrate 11 is exposed is provided so as to surround the protective layer 15.

Specifically, as shown in Figs. 2, 3, and 4, the protective layer 15 is not formed and the light receiving surface is exposed in a region from the circumference of the light receiving surface of the solar cell substrate 11 to the inside by a predetermined distance.

Moreover, as shown in Figs. 2 and 3, the protective layer 15 is not formed and the light receiving surface is exposed on the connecting electrode 14 and in the circumference of the connecting electrode 14.

On the other hand, as shown in Figs. 2 and 4, the protective layer 15 is formed on the thin wire electrode 13 and in the circumference of the thin wire electrode 13.

As mentioned above, while the protective layer 15 is formed almost entirely over the light receiving surface of the solar cell substrate 11, the region in which the light receiving surface of the solar cell substrate 11 is exposed is provided so as to surround the protective layer 15.

Alternatively, the protective layer 15 may be formed to be in contact with the side surfaces of the connecting electrode 14.

Moreover, a length in an arrangement direction of the protective layer 15 is approximately equal to that of the connecting electrode 14 in Fig. 2. However, the length in the arrangement direction of the protective layer 15 may be different from that of the connecting electrode 14.

When the length in the arrangement direction of the protective layer 15 is set to be longer than that of the connecting electrode 14, the protective layer 15 may be formed so as to surround the connecting electrode 14, as shown in Fig. 5. In this case, in order to prevent a space from being left between the connecting electrode 14 and the wiring member 20 bonded thereon, the protective layer 15 preferably has a thickness smaller than that of the connecting electrode 14, the protective layer 15 being formed in an extension of the connecting electrode 14 on the light receiving surface of the solar cell substrate 11.

### (Method for Manufacturing Solar Cell Module)

Next, a method for manufacturing a solar cell module according to the first embodiment of the present invention will be described.

First, the photoelectric conversion part 12 is formed. Next, a plurality of thin wire electrodes 13 are formed in a first direction on the light receiving surface of the photoelectric conversion part 12. Subsequently, a connecting electrode 14 is formed on the light receiving surface of the photoelectric conversion part 12 in a second direction approximately perpendicular to the first direction. Similarly, a plurality of thin wire electrodes 13 and another connecting electrode 14 are also formed on the back surface of the photoelectric conversion part 12. In this way, the solar cell substrate 11 is formed.

Next, the protective layer 15 formed of a translucent resin is formed on the light receiving surface of the solar cell substrate 11. At this point, on the light receiving surface of the solar cell substrate 11, a region in which the light receiving surface of the solar cell substrate 11 is exposed is provided so as to surround the protective layer 15.

As a method for forming the protective layer 15, methods (for example, offset printing method, roll coating method, etc.) can be used in which a liquid or gel translucent resin applied to a curved surface of a roller is transferred on the light receiving surface of the photoelectric conversion part 12 with the roller being rolled.

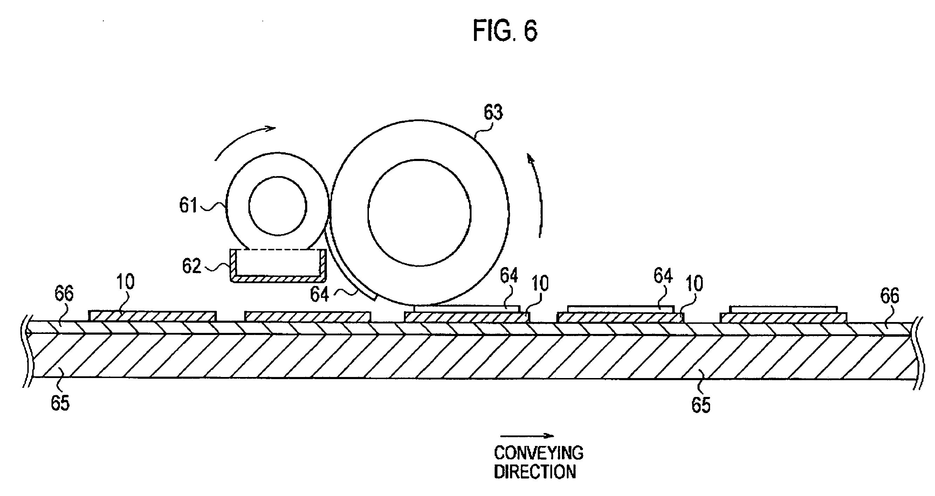

Specifically, a method for forming the protective layer 15 will be described with reference to Fig. 6. Fig. 6 is a schematic diagram showing a method for forming the protective layer according to the first embodiment of the present invention.

Concave portions having a specific pattern are formed on a curved surface of a cylindrical printing cylinder 61. Here, the specific pattern refers to a shape corresponding to a shape of the protective layer 15 to be formed on the light receiving surface of the solar cell substrate 11. For example, the specific pattern can be the shape of the protective layer 15 shown in Fig. 2.

The liquid or gel resin is accumulated in a resin tub 62. The rotating printing cylinder 61 is dipped in the liquid or gel resin accumulated in the resin tub 62. Accordingly, on the curved surface of the printing cylinder 61, the resin attached to a region other than the concave portions is removed, so the resin remains only in the concave portions. On the curved surface of the printing cylinder 61, it is not needed to have difference in height between the region in which the resin is removed and the region in which the resin remains. Specifically, the region in which the resin is removed may be chemically separated from the region in which the resin remains.

A curved surface of a cylindrical blanket 63 is formed of an elastic member. The blanket 63 rotates in a direction opposite to a rotating direction of the printing cylinder 61, while causing its curved surface being in contact with the curved surface of the printing cylinder 61. Then, the resin remaining in the concave portions of the printing cylinder 61 is transferred on the curved surface of the blanket 63. At this time, the resin to be transferred onto the curved surface of the blanket 63 has the specific pattern. Hereinafter, the resin having the specific pattern is referred to as a specific pattern resin 64.

A conveying device 65 conveys the solar cell substrate 11 mounted on a flat mounting base 66 in a predetermined conveying direction. The solar cell substrate 11 is mounted on the mounting base 66 with the light receiving surface facing upward. A belt conveyor, etc. can be used as the conveying device 65. The conveying device 65 causes the solar cell substrate 11 mounted on the mounting base 66 to pass through under the rotating blanket 63. At this time, the specific pattern resin 64 transferred onto the curved surface of the blanket 63 is transferred on the light receiving surface of the solar cell substrate 11. The liquid or gel specific pattern resin 64 transferred onto the light receiving surface of the solar cell substrate 11 is cured by drying. Thereby, the protective layer 15 is formed on the light receiving surface of the solar cell substrate 11, and consequently, the solar cell 10 is made.

Next, the wiring member 20 is connected to the connecting electrode 14 formed on the light receiving surface of the photoelectric conversion part 12, the wiring member 20 connecting one solar cell 10 including the photoelectric conversion part 12 with different solar cell 10 adjacent to one side of the one solar cell 10. Additionally, the wiring member 20 is connected to the connecting electrode 14 formed on the back surface of the photoelectric conversion part 12, the wiring member 20 connecting the one solar cell 10 including the photoelectric conversion part 12 with still different solar cell 10 adjacent to the other side of the one solar cell 10. Thereby, the one solar cell 10, the different solar cell 10 adjacent to the one side of the one solar cell 10, and the still different solar cell 10 adjacent to the other side of the one solar cell 10 are electrically connected.

Next, on the light-receiving-surface-side protective member 30, the sealing member 50, a plurality of solar cells 10 each being connected to each other by the wiring member 20, and the sealing member 50 and the back-surface-side protective member 40 are sequentially stacked so as to form a stacked body.

Next, the solar cell module 100 is manufactured by thermal compressing the stacked body in a vacuum atmosphere.

### (Action and effect)

In the solar cell 10 according to the first embodiment of the present invention, the region in which the light receiving surface of the solar cell substrate 11 is exposed is formed on the outside of the circumference of the protective layer 15 formed on the light receiving surface of the solar cell substrate 11.

Therefore, even when the translucent resin that forms the protective layer 15 has high fluidity immediately after being transferred onto the light receiving surface of the solar cell substrate 11, the translucent resin can avoid overflowing to the outside of the light receiving surface of the solar cell substrate 11.

Accordingly, the translucent resin that forms the protective layer 15 is prevented from intruding into a space between the solar cell substrate 11 and the mounting base 66, thus, is prevented from adhering onto the connecting electrode 14 formed on the back surface of the solar cell substrate 11. Consequently, faulty connection between the connecting electrode 14 formed on the back surface of the solar cell substrate 11 and the wiring member 20 can be prevented from occurring.

Furthermore, it is possible to prevent the solar cell substrate 11 and the mounting base 66 from being fixed to each other. Therefore, the solar cell substrate 11 having the protective layer 15 formed on the light receiving surface can be prevented from being damaged when being detached from the mounting base 66. Consequently, it is possible to avoid reduction in the production efficiency of the solar cell substrate 11 having the protective layer 15 formed on the light receiving surface, i.e., the solar cell 10.

### [Example]

Hereinafter, a method for manufacturing solar cell module according to the present invention will be described in detail, giving examples. However, the present invention is not limited to what will be shown in the following examples, and can be properly changed and can be performed within the scope in which the gist is not changed.

### (Example 1)

A solar cell according to Example 1 was manufactured in the following way.

First, prepared was a solar cell substrate including, on the light receiving, a plurality of thin wire electrodes formed in the first direction and the connecting electrode formed in the second direction approximately perpendicular to the first direction surface.

Next, using offset printing method, an acrylic resin having the specific pattern was transferred on the light receiving surface of the solar cell substrate formed into 100 mm square. Here, the area of the specific pattern was formed smaller than the area of the light receiving surface of the solar cell substrate. Accordingly, the region in which the light receiving surface of the solar cell substrate is exposed was provided so as to surround the acrylic resin transferred onto the light receiving surface of the solar cell substrate.

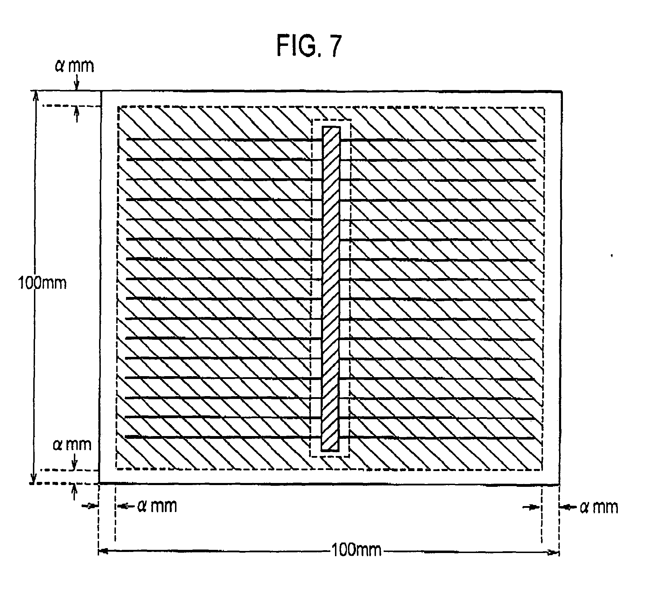

Fig. 7 is a plan view of the light receiving surface side of the solar cell according to the example. In a solar cell according to Example 1, a width α of the region in which the light receiving surface of the solar cell substrate is exposed was set to be 1 mm. Even when the width α of the region in which the light receiving surface of the solar cell substrate is exposed was 1 mm, the acrylic resin did not overflow to the outside of the circumference of the light receiving surface of the solar cell substrate.

### (Example 2)

A solar cell according to Example 2 was manufactured in the following way.

First, 100 mm square of a solar cell substrate was prepared in the similar manner to the case in Example 1 mentioned above . Then, an acrylic resin having the specific pattern was transferred on the light receiving surface of the solar cell substrate in the similar manner to the case of Example 1 mentioned above.

In the solar cell according to Example 2, the width α of the region in which the light receiving surface of the solar cell substrate is exposed was set to be 2 mm. Even when the width α of the region in which the light receiving surface of the solar cell substrate is exposed was 2 mm, the acrylic resin did not overflow to the outside of the circumference of the light receiving surface of the solar cell substrate.

### (Comparative Example 1)

A solar cell according to Comparative Example 1 was manufactured in the following way.

First, a solar cell substrate similar to those used in Example 1 and Example 2 mentioned above was prepared. Next, an acrylic resin was transferred entirely over the light receiving surface of the solar cell substrate using offset printing method.

### (Comparative Example 2)

In Comparative Example 2, a solar cell substrate similar to those in Example 1 and Example 2 mentioned above was prepared. However, in Comparative Example 2, the entire light receiving surface was exposed without forming a protective layer on the light receiving surface of the solar cell substrate.

### (Humidity resistance test)

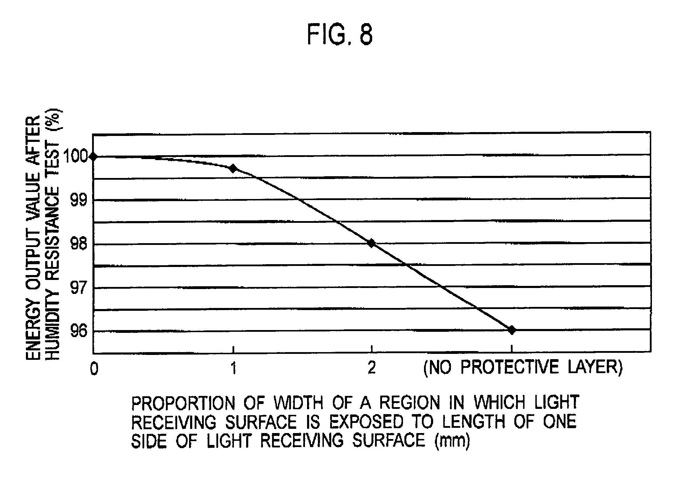

Humidity resistance test was conducted for the above-mentioned Example 1, Example 2, Comparative Example 1, and Comparative Example 2. Fig. 8 is diagram showing each energy output value of the solar cells according to Example 1, Example 2, Comparative Example 1, and Comparative Example 2 after the humidity resistance test. The test conditions were set at a temperature of 85°C and at a humidity of 85%, and a test period was set at 1000 hours. In Fig. 8, the energy output values of the solar cells according to Example 1, Example 2, and Comparative Example 2 after the humidity resistance test are shown as the normalized value by using the energy output value of the solar cell according to Comparative Example 1 after the humidity resistance test being defined as 1.00.

As shown in Fig. 8, after the humidity resistance test, the solar cell according to Example 1 was able to maintain 99.7% of the energy output value of the solar cell according to Comparative Example 1 after the humidity resistance test. Moreover, after the humidity resistance test, the solar cell according to Example 2 was able to maintain 98.0% of the energy output value of the solar cell according to Comparative Example 1 after the humidity resistance test.

On the other hand, the solar cell according to Comparative Example 2 was able to maintain only 96.0% of the energy output value of the solar cell according to Comparative Example 1 after the humidity resistance test. The reason is that the protective layer is not formed on the light receiving surface of the solar cell substrate in Comparative Example 2. Therefore, moisture in the atmosphere permeates through the photoelectric conversion part more easily, compared with Example 1, Example 2, and Comparative Example 1 so that of the pn semiconductor junction of the photoelectric conversion part is deteriorated in higher extent.

As mentioned above, by setting the width α of the region in which the light receiving surface is exposed to be not more than 2 mm, loss of the energy output value can be limited within 2% of the energy output value of the solar cell having the protective layer entirely formed over the light receiving surface after the humidity resistance test.

Particularly, by setting the width α of the region in which the light receiving surface is exposed to be not more than 1 mm, it is possible to obtain the energy output value approximately equal to that of the solar cell having the protective layer entirely formed over the light receiving surface after the humidity resistance test. Thus, it was confirmed that the width α of the region in which the light receiving surface is exposed is particularly preferably not more than 1 mm.

### (Other embodiments)

Although the present invention has been described using the above-mentioned embodiment, it should not be understood that the invention is limited by the statements and drawings that constitute a part of this disclosure. From this disclosure, various alternative embodiments, examples, and implementing techniques will be obvious to those skilled in the art.

For example, in the first embodiment mentioned above, the protective layer is formed only on the light receiving surface of the solar cell, and in the second embodiment, the protective layer is formed on the light receiving surface as well as the back surface of the solar cell 10, but the present invention is not limited to these. Specifically, the protective layer may be formed only on the back surface of the solar cell. Alternatively, the protective layer may be formed on both of the light receiving surface and the back surface. It should be noted that when the protective layer is formed only on either one of the light receiving surface and the back surface, preferably, the protective layer is formed on a surface close to a region in which the pn semiconductor junction is formed within the photoelectric conversion part. The reason is that the photoelectric conversion efficiency of the solar cell is easily reduced when the pn semiconductor junction is deteriorated due to moisture that permeates through the photoelectric conversion part.

In the first embodiment and second embodiment mentioned above, the protective layer is formed by the offset printing method or roll coating method, but the present invention is not limited to these. Specifically, the protective layer may be formed using alternative coating methods, such as spray method, screen printing method, and dip method.

In the first embodiment and second embodiment mentioned above, the photoelectric conversion part includes the connecting electrode, but the present invention is not limited to this. Specifically, the photoelectric conversion part may not include the connecting electrode, and the wiring member may be directly connected to the thin wire electrode.

Furthermore, in the first embodiment and second embodiment mentioned above, the thin wire electrode and the connecting electrode are formed in a comb shape on the back surface of the photoelectric conversion part, but the present invention is not limited to this. Specifically, a collector electrode that collects the photogenerated carriers may be formed to cover the whole back surface of the photoelectric conversion part. The present invention does not limit the shape of the collector electrode formed on the back surface of the photoelectric conversion part.

In the first embodiment and second embodiment mentioned above, on the light receiving surface of the photoelectric conversion part, the thin wire electrode is formed in a line form in the direction approximately perpendicular to the arrangement direction of the plurality solar cells, but the thin wire electrode does not need to be in a line form. The present invention does not limit the shape of the thin wire electrode.

Additionally, the width of the region in which the light receiving surface is exposed may be increased or decreased depending on a kind of a translucent resin that forms the protective layer, viscosity of the translucent resin when transferring the translucent resin on the light receiving surface or back surface of the solar cell, or the like.

As described above, apparently, the present invention includes various embodiments and the like that have not been described here. Consequently, the technical scope of the present invention will be determined only by specified matters of invention according to the appropriate scope of claims as interpreted by the description and drawings.

## Claims

1. A method for manufacturing a solar cell module including one solar cell and other solar cell which are arranged in an arrangement direction, and a wiring member configured to electrically connect the one solar cell with the other solar cell, the method comprising the steps of:
forming a protective layer formed of a resin material on one main surface of the one solar cell; and
arranging the wiring member on the one main surface; wherein
in the forming step, a region in which the one main surface is exposed is provided so as to surround the protective layer.

2. The method for manufacturing the solar cell module according to claim 1, wherein
in the forming step, the region in which the one main surface is exposed is provided as a region in which the wiring member is arranged.

3. A solar cell module including one solar cell and other solar cell which are arranged in an arrangement direction, and a wiring member configured to electrically connect the one solar cell with the other solar cell wherein
the one solar cell includes:
one main surface; and
a protective layer formed of a transparent member on the one main surface,
the wiring member is arranged on the one main surface, and
a region in which the one main surface is exposed is formed in the one solar cell so as to surround the protective layer.

4. A method for manufacturing a solar cell having a protective layer formed of a resin material on one main surface, the method comprising a step of:
forming the protective layer on the one main surface, wherein
in the forming step, a region in which the one main surface is exposed is provided so as to surround the protective layer.

5. A solar cell comprising
one main surface; and
a protective layer formed of a transparent member on the one main surface, wherein
a region in which the one main surface is exposed is formed so as to surround the protective layer.
